(19) Europäisches Patentamt
European Patent Office
Office européen des brevets

(11) **EP 3 247 576 B1**

(12) **EUROPÄISCHE PATENTSCHRIFT**

(45) Veröffentlichungstag und Bekanntmachung des Hinweises auf die Patenterteilung:
**12.12.2018 Patentblatt 2018/50**

(21) Anmeldenummer: **16709965.4**

(22) Anmeldetag: **19.01.2016**

(51) Int Cl.:
*B60C 23/04* (2006.01)     *G01S 13/88* (2006.01)
*H01Q 1/22* (2006.01)     *G01S 7/02* (2006.01)
*G01S 7/35* (2006.01)     *G01S 13/36* (2006.01)
*G01N 22/00* (2006.01)     *G01S 7/40* (2006.01)
*G01R 27/28* (2006.01)     *G01M 17/02* (2006.01)
*G01S 13/75* (2006.01)     *G01L 17/00* (2006.01)

(86) Internationale Anmeldenummer:
**PCT/DE2016/100021**

(87) Internationale Veröffentlichungsnummer:
**WO 2016/116098 (28.07.2016 Gazette 2016/30)**

(54) **VORRICHTUNG ZUM MESSEN VON REIFENBEZOGENEN GRÖSSEN EINES FAHRZEUGS**

DEVICE FOR MEASURING TIRE-RELATED VARIABLES OF A VEHICLE

DISPOSITIF DE MESURE DE GRANDEURS LIÉES AUX PNEUMATIQUES D'UN VÉHICULE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.01.2015 DE 102015100890**

(43) Veröffentlichungstag der Anmeldung:
**29.11.2017 Patentblatt 2017/48**

(73) Patentinhaber: **Fachhochschule Aachen**
**52066 Aachen (DE)**

(72) Erfinder:
• **HEUERMANN, Holger**
**52076 Aachen (DE)**

• **HARZHEIM, Thomas**
**52249 Eschweiler (DE)**

(74) Vertreter: **Ostermann, Thomas**
**Fiedler, Ostermann & Schneider**
**Patentanwälte**
**Klausheider Strasse 31**
**33106 Paderborn (DE)**

(56) Entgegenhaltungen:
WO-A1-03/027709     WO-A2-2010/120558
DE-A1- 2 461 212     DE-A1- 4 117 158
DE-A1- 4 326 976     DE-A1-102009 013 458
US-A1- 2002 189 336

**Beschreibung**

Die Erfindung betrifft eine Vorrichtung zum Messen und/oder Überwachen von reifenbezogenen Messgrößen eines Fahrzeugs nach dem Oberbegriff des Patentanspruchs 1.

Aus der DE 24 61 212 A1 ist eine Vorrichtung zum Messen eines Drucks von Reifen eines Fahrzeugs bekannt, die eine Sende-/Empfangseinrichtung mit einem Oszillator zur Erzeugung eines Sendesignals in einem Mikrowellenfrequenzbereich aufweist. Ferner weist die Sende-/Empfangseinrichtung eine Antenneneinheit auf, über die das Sendesignal in Richtung eines an einem Felgenbett eines Rades angeordneten kompressiblen Messobjektes abgestrahlt werden kann. Ferner weist die Sende-/Empfangseinrichtung eine Auswerteeinheit und eine Empfangsantenne auf, so dass bei Ausdehnung des kompressiblen Messobjektes die Frequenzänderung eines Reflexionssignals erkannt werden kann. Das kompressible Messobjekt weist einen von dem Luftdruck des Reifens abhängigen ausfahrbaren Abschnitt auf, der zu einer Änderung der Frequenz des Reflexionssignales führt und hierdurch eine Reifendruckänderung abgeleitet werden kann. Nachteilig an der bekannten Vorrichtung ist, dass die Störanfälligkeit aufgrund von sich ändernden Umgebungsbedingungen relativ groß ist.

Aus der DE 10 2009 013 458 A1 ist eine Vorrichtung zum Messen und/oder Überwachen von reifenbezogenen Größen eines Fahrzeugs bekannt, die eine Sensoreinheit mit einer Sende-/Empfangseinrichtung sowie eine Auswerte- und Antenneneinheit aufweist. Von der Antenneneinheit wird ein Sendesignal in Richtung eines Messobjektes abgestrahlt. Anhand eines von dem Messobjekt reflektierten Reflexionsstrahls kann auf die Entfernung des Messobjektes von der Antenneneinheit geschlossen werden. Hierzu wird das Verhältnis der gesendeten Leistung zu der reflektierten Leistung gebildet. Der aktuelle Zustand des Messobjektes kann hierdurch nicht detektiert werden.

Aus der DE 43 26 976 A1 ist eine Vorrichtung zum Messen und/oder Überwachen von reifenbezogenen Messgrößen eines Fahrzeugs bekannt, wobei eine Sensoreinheit mit einer Antenneneinheit und einer Sende-/Empfangseinrichtung vorgesehen ist. Zur Messung der reifenbezogenen Messgröße ist ein Messmodul innerhalb des Reifens erforderlich.

Aus der WO 03/027709 A1 ist eine Vorrichtung zum Messen und/oder Überwachen von reifenbezogenen Messgrößen eines Fahrzeugs bekannt. Die Vorrichtung weist eine Sensoreinheit auf, die eine Antenneneinheit sowie eine Sende-/Empfangseinrichtung aufweist. Sie ist dazu geeignet, die Phasendifferenz zwischen einem Sendesignal und einem Reflexionssignal zu ermitteln, damit eine Entfernung zu dem Messobjekt ermittelbar ist. Die bekannte Messvorrichtung ist geeignet, eine Bremsscheibe eines Kraftfahrzeuges zu vermessen. Die bekannte Vorrichtung weist keine Reflektorelemente auf, so dass ein Reflexionssignal in Abhängigkeit von einem Lenkeinschlag eines Rades veränderlich ist.

Aufgabe der vorliegenden Erfindung ist es daher, eine Vorrichtung zum Messen und/oder Überwachen von reifenbezogenen Größen eines Fahrzeugs derart weiterzubilden, dass eine langzeitstabile und genaue Messung von fahrzeugrelevanten Größen, insbesondere des Reifendrucks, gewährleistet ist.

Zur Lösung dieser Aufgabe weist die Erfindung die Merkmale des Patentanspruchs 1 auf.

Nach der Erfindung ist ein vektorieller Netzwerkanalysator (VNA) vorgesehen, mittels dessen eine preiswerte und robuste Überwachung bzw. Messung von Messobjekten gewährleistet ist. Vorteilhaft können mehrere Messgrößen mit ein und derselben Messung erfasst werden. Die Messdatenübertragung erfolgt im Mikrosekundenbereich. Ferner weist die erfindungsgemäße Vorrichtung ein geringes Gewicht auf. Nach der Erfindung können auf dem Messobjekt in Umfangsrichtung in unterschiedlichen Richtungen orientierte Reflektorelemente, vorzugsweise um 90° versetzt zueinander, angeordnet sein, so dass zusätzlich eine Einschlagswinkelmessung des Rades gewährleistet ist.

Nach einer Weiterbildung der Erfindung kann der Netzwerkanalysator dafür eingesetzt werden, den Reifendruck, die Umdrehungsgeschwindigkeit, den Radeinschlagwinkel, die Einfedertiefe, die Straßenfeuchtigkeit sowie metallische Fremdkörper im Reifen zu erfassen.

Nach einer Weiterbildung der Erfindung ist die Sende-/Empfangseinrichtung in einem Radkasten eines Fahrzeugs angeordnet. Das Messobjekt ist als ein kompressibles Strukturelement ausgebildet, das innerhalb eines durch einen Reifen und eine Felge des Rades begrenzten Innenraumes in Umfangsrichtung des Rades angeordnet ist. Die Antenneneinheit der Sende-/Empfangseinrichtung ist auf das kompressible Strukturelement ausgerichtet. Es wird nur der Bereich des kompressiblen Strukturelementes erfasst. Da das Strukturelement druckempfindlich ist, erfolgt eine radiale Verformung desselben, wenn sich der Reifendruck ändert. Es ändert sich somit die Materialkonstante $\varepsilon_r$. Dadurch, dass sich bei Änderung der radialen Verformung des kompressiblen Strukturelementes eine Phasendifferenz zwischen einer einfallenden Welle (Sendesignal) und einer reflektierten Welle (Reflexionssignal) einstellt, kann auf den aktuellen Druck des Reifens geschlossen werden.

Nach einer Weiterbildung der Erfindung ist das kompressible Strukturelement außenseitig mit einer Anzahl von Reflektorelementen versehen, so dass die Erfassung der radialen Verformung des Strukturelementes verbessert werden kann. Vorzugsweise sind die Reflektorelemente in Umfangsrichtung des Strukturelementes aufmetallisiert bzw. bestehen aus einem Metallmaterial.

Nach einer Weiterbildung der Erfindung wird die Sende-/Empfangseinrichtung von einer Steuereinheit mittels eines Pseudozufallszahlengenerators angesteuert, so dass eine Störunterdrückung zwischen den jeweils den Reifen zugeordneten Sende-/Empfangseinheiten gewährleistet ist. Die Wahrscheinlichkeit einer unerwünschten Interferenz zwischen den verbauten Sende-/Empfangseinheiten an demselben oder anderen Fahrzeugen wird hierdurch gemindert.

Nach einer Ausführungsform der Erfindung ist das Strukturelement als ein Mikrowellenhohlraumabsorber ausgebildet, so dass durch Ermittlung einer Resonanzfrequenz eine Änderung des Luftdrucks des Reifens ableitbar ist. Das Messobjekt ist somit kein druckgefüllter Körper. Vorteilhaft kann hierdurch die Signalverarbeitung erleichtert werden. An die in Mikrowellenhohlraumabsorber integrierten flexiblen Membranen können relativ geringe Anforderungen hinsichtlich Diffusionseigenschaften gestellt werden.

Nach einer Weiterbildung der Erfindung weist die Sende-/Empfangseinrichtung eine Zusatzantenne auf, deren Polarisationsebene um 90° zu der Antenne gedreht ist. Hierdurch können zwei Reflexionssignale gleichzeitig erfasst werden, damit zum einen der Reifendruck und zum anderen die Einschlagswinkelmessung des Rades gewährleistet ist.

Nach einer Weiterbildung der Erfindung weist die Sende-/Empfangseinrichtung eines weitere Antenne auf, die auf eine Breite der Felge und/oder des Rades ausgerichtet ist, so dass durch Phasendifferenz des Reflexionssignals zu dem Sendesignal ein Fremdkörper an oder in dem Reifen ermittelbar ist. Vorteilhaft kann somit festgestellt werden, ob beispielsweise ein Nagel in dem Reifen eingebracht worden ist.

Weitere Vorteile der Erfindung ergeben sich aus den weiteren Unteransprüchen.

Ausführungsbeispiele der Erfindung werden nachfolgend anhand der Zeichnungen näher erläutert:

Es zeigen:

Fig. 1 eine schematische Darstellung einer erfindungsgemäßen Vorrichtung, die in einem Radkasten bzw. einem Rad eines Fahrzeugs angeordnet ist,

Fig. 2 einen Querschnitt eines Rades mit in einem Felgenbett integrierten kompressiblen Strukturelement zur Ermittlung eines Reifendrucks des Rades,

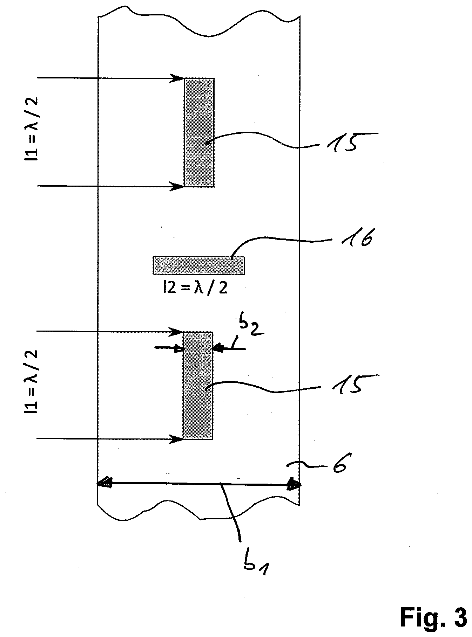

Fig. 3 eine Draufsicht auf einen Ausschnitt des kompressiblen Strukturelementes gemäß Figur 3,

Fig. 4 einen Querschnitt durch das Rad mit einem als Mikrowellenhohlraumabsorber ausgebildeten Strukturelement, das in dem Felgenbett angeordnet ist zur Ermittlung des Reifendrucks,

Fig. 5 eine perspektivische Darstellung des Mikrowellenhohlraumabsorbers,

Fig. 6 eine Seitenansicht des Mikrowellenhohlraumabsorbers und

Fig. 7 einen Querschnitt des Rades, bei dem im Unterschied zu der Messung gemäß Figur 4 der Mikrowellenhohlraumabsorber zur Radparametermessung benutzt wird.

Eine Vorrichtung zum Messen und/oder Überwachen von reifenbezogenen Messgrößen eines Fahrzeugs weist eine Sensoreinheit 1 auf, die im Wesentlichen eine Sende-/Empfangseinrichtung 2 umfasst, die in einem Radkasten 3 eines Fahrzeugs (KFZ) integriert ist. Die Sensoreinheit 1 kann mit einer ortsfern, vorzugsweise im Fahrzeug angeordneten Steuereinheit 4 über Signalleitungen, beispielsweise einen CAN-Bus, verbunden sein. Zur Messung bzw. Überwachung eines Reifendrucks eines Rades 5 des Fahrzeugs ist ein Strukturelement 6 als Messobjekt in einem durch einen Reifen 7 und durch eine Felge 8 des Rades 5 begrenzten Innenraum 9 angeordnet.

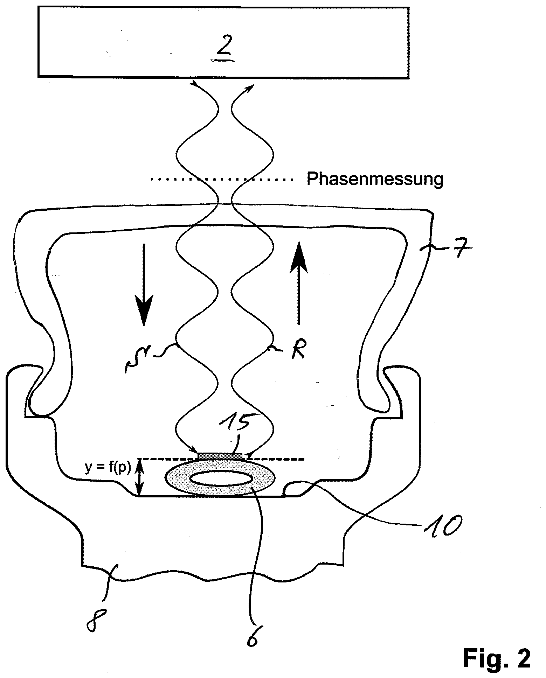

Nach einer ersten Ausführungsform der Erfindung gemäß Figur 2 ist das Strukturelement 6 als ein kompressibles Strukturelement ausgebildet, das in einem Felgenbett 10 der Felge 8 positioniert bzw. befestigt ist.

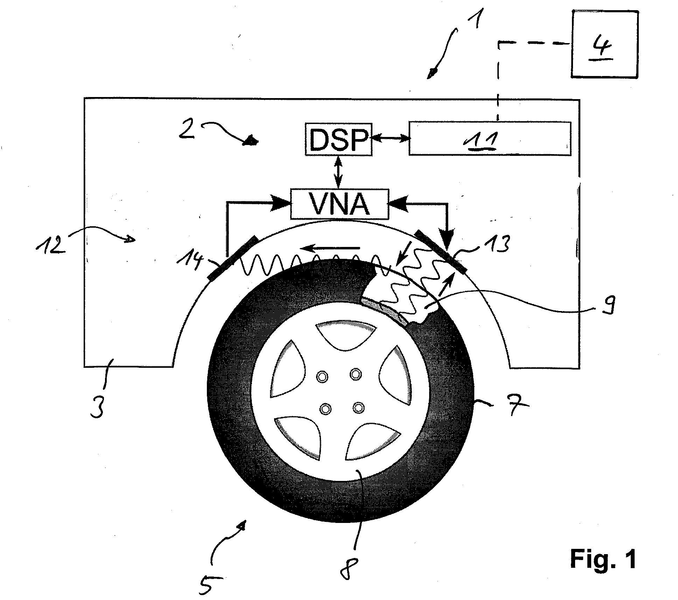

Wie aus Figur 1 zu ersehen ist, weist die Sende-/Empfangseinrichtung 2 einen vektoriellen Netzwerkanalysator VNA, eine Auswerteeinheit 11, einen zwischen der Auswerteinheit 11 und dem Netzwerkanalysator VNA angeordneten digitale Signalprozessoreinheit DSP sowie eine Antenneneinheit 12 enthaltend eine Sende-/Empfangsantenne 13 und eine Empfangsantenne 14 auf.

Der Netzwerkanalysator VNA weist einen Oszillator auf, der ein sinusförmiges Messsignal im Mikrowellenfrequenzbereich von beispielsweise 300 MHz bis 300 GHz erzeugt, vorzugsweise zwischen 6,0 und 8,5 GHz. Die Sende-/Empfangseinrichtung 2 weist einen Mikroprozessor zur Signalverarbeitung und Steuerung sowie einen Bus-Schaltkreis zur leitungsgebundenen Datenübertragung über eine Bus-Verbindung mit einer dezentralen oder der zentralen ortsfern angeordneten Steuereinheit 4 auf. Vorzugsweise weist die Sende-/Empfangseinrichtung 2 zusätzlich noch eine DC-DC-Wandlereinheit auf. Der Netzwerkanalysator VNA weist ferner einen Prozessor sowie Messtore auf, wobei der Prozessor über Richtkoppler mit dem Messtoren verbunden ist. Somit kann der Netzwerkanalysator VNA ein Sendesignal S erzeugen, das über die Sende-/Empfangsantenne 13 der Antenneneinheit 12 an das kompressible Strukturelement 6 übertragen wird. Mittels der Sende-/Empfangsantenne 3 wird ein Reflexionssignal R, das an dem kompressiblen Strukturelement 6 reflektiert wird, empfangen und in der Auswerteeinheit 11 unter Ermittlung einer Phasendifferenz zwischen dem Sendesignal S und dem Reflexionssignal R ausgewertet.

Zur Erhöhung der Messgenauigkeit weist das kompressible Strukturelement 6, das als kreisförmiger Endlosschlauch ausgebildet ist, der sich in Umfangsrichtung des Rades 5 unter Anlage an dem Felgenbett 10 erstreckt, außenseitig eine Anzahl von in Umfangsrichtung orientiert angeordneten ersten Reflektorelementen 15 auf. Diese ersten Reflektorelemente 15 sind in einem Abstand zueinander in Umfangsrichtung angeordnet. Die Länge der ersten Reflektorelemente 15 bestimmen die Arbeitsfrequenz bzw. die Frequenz des Sendesignals S. Während das kompressible Strukturelement 6 als ein Gummischlauch ausgebildet sein kann, kann das erste Reflektorelement 15 aus einem Metallmaterial bestehen. Das erste Reflektorelement 15 besteht aus einem mikrowellenabsorbierenden Material. Dies bewirkt, dass das erste Reflektorelement 15 im Betrag der Reflexionsmessung deutlich gegenüber dem ansonsten stark reflektierenden Hintergrund des Felgenbettes 10 hervortritt. Dies ist darin begründet, dass bei den Frequenzen, für die das Reflektorelement 15 eine Länge $l_1$ von etwa $\lambda/2$ aufweist, die Wellen primär von diesem reflektiert werden. Der Anteil der nicht von diesem resonanten ersten Reflektorelement 15 reflektierten Wellen, transmittiert bei seiner Reflexion an dem Felgenbett 10 zweimal das mikrowellenabsorbierende Material 15 und wird dementsprechend abgedämpft. Folglich kann hierdurch die Felgenreflexion als Störgröße erheblich reduziert werden. Darüber hinaus kann eine Fensterung dadurch vereinfacht und das effektive Signal-Zu-Rausch-Verhältnis ansteigen. Darüber hinaus ist auch eine exakte Bestimmung der Arbeitsfrequenz des passiven Reflektorelementes 15 im Betrag der S11-Messung möglich. Die Anforderungen an die Fertigungsgenauigkeit des Reflektorelementes 15 können hierdurch verringert werden. Aus dem lokalen Maximum der S11-Messung lässt sich der exakte Frequenzpunkt für die Phasenmessung bestimmen.

Hierzu ist es sinnvoll, dass die Sende-/Empfangsantenne 13 ausschließlich auf das Strukturelement 6 bzw. die ersten Reflektorelemente 15 ausgerichtet ist. Der maximale Erfassungsbereich in axialer Richtung ist durch eine Breite $b_1$ des Strukturelementes 6 begrenzt. Diese Bedingung gilt, wenn der Reifendruck ausschließlich mit dem Strukturelement 6, aber nicht mit dem ersten Reflektorelement 15 gemessen wird.

Erfolgt die Messung des Reifendrucks unter Einschluss der in der Länge $l_1$ von $\lambda/2$ angeordneten streifenförmigen Reflektorelementen 15 auf dem Strukturelement 6, ist die Erfassungsbreite der Sende-/Empfangsantenne 13 auf eine Breite $b_2$ der streifenförmigen Reflektorelemente 15 begrenzt. Vorteilhaft ist die Sensoreinheit 1 bei dieser Variante in der Lage, neben dem Reifendruck auch die Geschwindigkeit des Rades bzw. des Reifens zu messen.

Die Sensoreinheit 1 ist geeignet, eine Einfedertiefe des Rades 5 zu messen. Hierzu erfolgt eine Phasenauswertung durch den Netzwerkanalysator VNA.

Die Sende-/Empfangseinrichtung 2 sendet ein Sinussignal mit der Frequenz fi (i: Laufindex) zum Reifen aus. An der Oberfläche des Reifens wird dieses Sinussignal zu einem nicht unerheblichen Teil reflektiert, d.h. zurück gestrahlt. Die Sende-/Empfangseinrichtung 2 empfängt das reflektierte und in der Phase veränderte sinusförmige Signal und wertet die Phase φ(fi) aus. Diese Messung wird bei weiteren Frequenzen durchgeführt. Aus der Phase über der Sendefrequenz lässt sich dann die Entfernungsinformation ermitteln.

Im Hochfrequenz- und Mikrowellenbereich gilt für die Ausbreitung im Freiraum der Ausbreitungskoeffizient

$$\beta(fi) = \beta i = (2 \pi fi) / c0 , \qquad (1)$$

wobei c0 die Lichtgeschwindigkeit angibt ([6]: Heuermann, H., Hochfrequenztechnik. Lineare Komponenten hochintegrierter Schaltungen, Vieweg-Verlag, ISBN 978-3-8348-07969-4, 2. Auflage Mai 2009).

Es gilt somit für die gesamte Phasendrehung der Reflexionsmessung über die Entfernung $\ell x$ für den Frequenzpunkt f1 am Eingang und am Empfänger:

$$\text{Phase(rg)} = 2 \beta 1 \, \ell x + rx , \qquad (2)$$

wobei rx der bekannte Reflexionsfaktor der Reifenoberfläche ist.

Gemessen wird die Phase nur im Eindeutigkeitsbereich von 360°. Folglich gilt für gesamten Phasenwert von rg in Abhängigkeit vom Messwert der Phase von rm:

$$\text{Phase(rg)} = \text{Phase(rm)} + n \cdot 2 \pi , \qquad (3)$$

wobei n eine ganze Zahl ist, die im Weiteren noch bestimmt wird.

Die Messwerte des Reflexionsfaktors liegt von einer unteren Frequenz f1u bis zu einer oberen Frequenz f1o als Phasenwert von rum und rom vor. Zwischen den verschiedenen Messpunkten soll es keine Phasensprünge geben, die sich in der praktischen Mathematik auch einfach eliminieren lassen.

Aus diesen beiden Messwerten und den bekannten zugehörigen Frequenzpunkten lässt sich die Steigung der Phase über der Frequenz ermitteln:

$$S = \text{delta\_}\varphi/\text{delta\_}f = (Phase(rom) - Phase(rum))/(f1o - f1u) \ . \qquad (4)$$

Bei der beliebigen Frequenz fi gibt es aufgrund der Steigung eine Grundphasendrehung von

$$\varphi i = fi\ S \ . \qquad (5)$$

Gleichung (5) lässt sich auch mit fo = fi und fu = 0Hz und den zugehörigen Phasenwerten aus der Gleichung (4) ableiten. Durch die folgende Bedingung

$$180° < abs(Phase(rim) + n \cdot 2\ \pi - fi\ S) \qquad (6)$$

wird der richtige Wert für n gefunden.

Es gilt für die Längenbestimmung der Entfernung $\ell x$ basierend auf der Gleichung (2) für jeden Frequenzpunkt:

$$\ell x = (Phase(rg) - Phase(rx))/(2\ \beta 1) \ . \qquad (7)$$

Neben der exakten Lösung lässt sich rx auch durch eine einmalige Messung bei bekannter Länge bestimmen. In der Praxis wird Gleichung (7) für jeden gemessenen Frequenzpunkt ausgewertet, damit durch eine anschließende Mittelung stochastische Fehler minimiert werden.

Die Präzision dieser Messung steigt mit der Bandbreite (f1o - f1u) und der Anzahl der Messungen.

Die nunmehr berechnete Entfernung $\ell x$ ist proportional zur Federtiefe. Dieser Werte wird im Weiteren auch bei den anderen Messungen benötigt, wie im Abschnitt "Fensterung" noch erklärt wird.

Zur Bestimmung des Reifendrucks wird die Phase des Reflexionssignals R (S11-Messung) mit der Phase des Sendesignals S verglichen. Ist das beispielsweise als Gummischlauch ausgebildete Strukturelement 6 nicht komprimiert, so befindet sich deutlich mehr Gummi in der Funkstrecke als im komprimierten Zustand. Über die sich ändernde Menge an dielektrischem Material verändern sich die Phasenmessresultate, die somit proportional zum Druck sind. Die Messung der Verformung des Strukturelementes 6 wird durch die aufgebrachten Reflektorelemente 15 vereinfacht, da sich bei der Resonanzfrequenz der Reflektorelemente 15 diese gezielt zur Phasenmessung heranziehen lassen. Hierdurch kann die Genauigkeit der Messung erhöht bzw. die Messgenauigkeitsanforderung an den Netzwerkanalysator VNA reduziert werden.

Der Schmutz oder andere Störgrößen wie Felgenreflexion, Phasendrehung durch Reifen, Feuchtigkeitsfilm auf dem Gehäuse der Sende-/Empfangseinrichtung 2 verändert die Übertragungseigenschaften im Betrag und in der Phase. Dieser störende Effekt kann durch eine Fensterung für alle Messungen eliminiert werden. Hierzu sind Auswertemittel vorgesehen, dass das Reflexionssignal R durch inverse Fourier-Transformation in den Zeitbereich transformiert wird, dann die bekannten Zeitbereiche (Oberfläche des Gehäuses ist gegeben und fest und der Reifenabstand wurde gemessen) herausgefenstert und dann das somit gefilterte S11-Signal durch diskrete Fourier-Transformation in den Frequenzbereich zurücktransformiert wird. Nun ist das komplexe Reflexionsverhalten, das sich auf der Oberfläche der Felge 8 ergibt, das dominante Signal. Dieses Verfahren wird erst durch die Erfassung der Messwerte nach Betrag und Phase, d.h. vektoriell, möglich.

Nach einer weiteren Ausführungsform der Erfindung kann das kompressible Strukturelement 6 zusätzlich zweite Reflektorelemente 16 aufweisen, die in Axialrichtung des Reifens 7 bzw. der Felge 8 orientiert angeordnet sind. Die zweiten Reflektorelemente 16 sind somit senkrecht zu den ersten Reflektorelementen 15 angeordnet bzw. weisen die gleiche

Länge $l_2 = \lambda/2$ auf wie die ersten Reflektorelemente 15. Da sie um 90° gedreht sind, ist eine horizontale Polarisation und mittels der ersten Reflektorelemente 15 eine vertikale Polarisation gewährleistet. Hierdurch kann zusätzlich noch der Einschlagwinkel des Rades 5 gemessen werden.

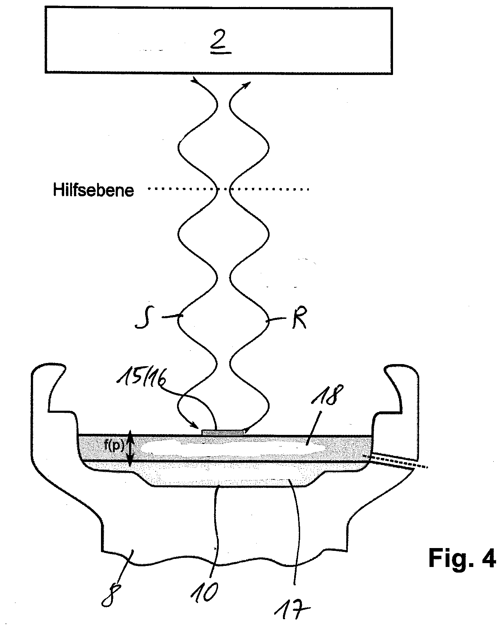

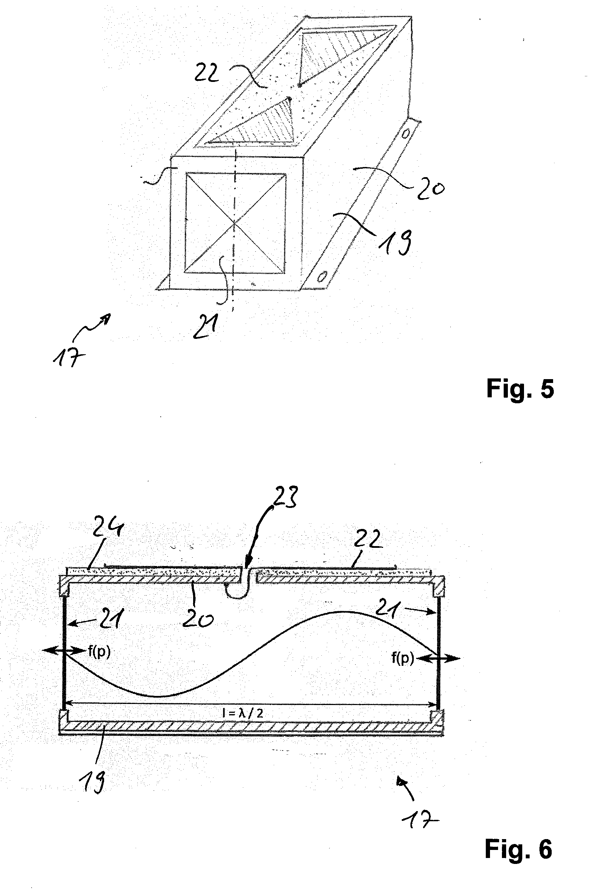

Nach einer weiteren Ausführungsform der Erfindung gemäß Figur 4 kann statt eines kompressiblen Strukturelementes 6 ein Mikrowellenhohlraumabsorber 17 vorgesehen sein, der von einem offenporigen Schaumstoffschicht 18 überdeckt sein kann, an dessen Außenseite die Anzahl von ersten Reflektorelementen 15 und/oder zweiten Reflektorelementen 16 angeordnet ist. Der Mikrowellenhohlraumabsorber 17 ist wie die Schaumstoffschicht 18 ringförmig angeordnet. Der Mikrowellenhohlraumabsorber 17 liegt unmittelbar im Felgenbett 10 der Felge 8 an. Wie aus den Figuren 5 und 6 deutlich wird, weist der Mikrowellenhohlraumabsorber 17 ein Gehäuse 19 enthaltend eine Längswandung 20 auf, die sich ringförmig entlang des Felgenbettes 10 erstreckt. Der Mikrowellenhohlraumabsorber 17 erstreckt sich teilkreisförmig in Umfangsrichtung, wobei der Abstand zwischen zwei endseitigen flexiblen Membranen 21 durch die Resonanzfrequenz vorgegeben ist. Die Länge I des Mikrowellenhohlraumabsorbers 17 beträgt somit $\lambda/2$. Auf einer zum Felgenbett 10 abgewandten Seite des Gehäuses 19 erstreckt sich außenseitig der Längswandung 20 eine Antenne 22. Die Antenne 22 ist über einen Schlitz 23 der Längswandung 20 an einer Innenseite der Längswandung 20 kontaktiert. Die Antenne 22 ist über eine Isolierung 24 auf der Längswandung 20 des Gehäuses 19 befestigt. Hiermit wird ein druckabhängiger Mikrowellenresonator bereitgestellt, dessen Resonanzfrequenz abhängig ist von dem Druck des Reifens 7. Die flexiblen Membranen 21 können beispielsweise aus einem biaxial orientierten Polyethylenterephthalat-Material bzw.- Folie (bo-PET, Mylaer) gebildet sein. Die Antenne 22 ist als eine planare Antenne ausgebildet.

Damit dieses Messsystem die notwendige Übersprecherisolation zwischen dem Sendesignal und dem Empfänger hat, ist es notwendig einmalig in der Produktion eine Systemfehlerkorrektur durchzuführen, wie es bei jedem kaufbaren VNA der Fall ist. Jedoch muss diese im Freiraum durchgeführt werden. Hierfür in Frage kommende Verfahren sind in dem Dokument: *"Heuermann, H., Sichere Verfahren zur Kalibrierung von Netzwerkanalysatoren für koaxiale und planare Leitungssysteme, Dissertationsschrift, Institut für Hochfrequenztechnik, Ruhr-Universität Bochum, 1995, ISBN 3-8265-1495-5)"* publiziert. Vorzugsweise lässt sich das Zweitorverfahren LNN verwenden. Alternativ lässt sich aus dem dargestellten S-3-R-Verfahren ein M-3-R-Verfahren herleiten, das sich ebenfalls für Freiraummessungen einsetzen lässt. Beim M-3-R-Verfahren werden vier Eintormessungen durchgeführt:

1) M-Messung: Antenne wird Richtung Himmel (oder Absorber) ausgerichtet.
2) 3-R-Messungen: Die Reflexion an einem Tripelspiegel wird in 3 Stellungen bei bekannten Abständen vermessen.

Aus diesen Kalibriermessungen werden für jeden Frequenzpunkt die 3 komplexen Fehlerkoeffizienten des 3-Term-Verfahrens berechnet. Mit diesen 3 komplexen Fehlerkoeffizienten bzw. -termen werden die Messwerte korrigiert und u.a. die Übersprecher zwischen Sende- und Empfangszweig heraus gerechnet.

Diese VNA-Kalibrierung ist vor einer beschriebenen Fensterung durchzuführen.

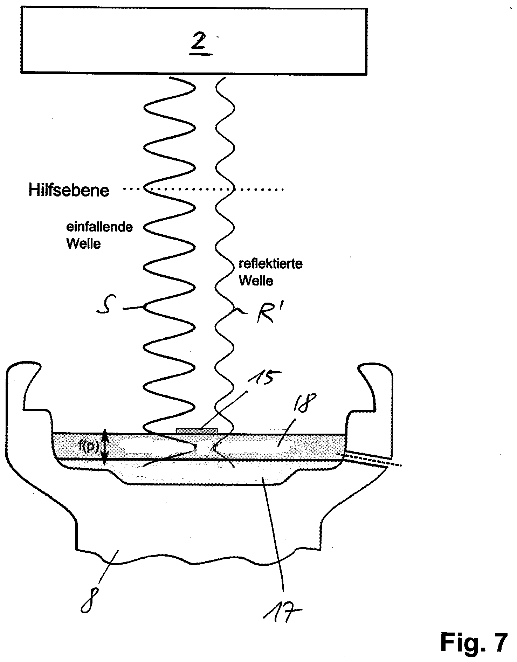

Nach einer weiteren Ausführungsform der Erfindung gemäß Figur 7 kann die Sende-/Empfangseinrichtung 2 auch genutzt werden, um ein Sendesignal S in Frequenzen außerhalb des Arbeitsbereiches des Mikrowellenhohlraumabsorbers 17 zu senden und zu empfangen zur Radparametermessung. Der Mikrowellenhohlraumabsorber 17 dämpft das Reflexionssignal R' dieser Frequenzen gegenüber der Resonatorreflexion. Damit können die Resonatoren in den Messergebnissen leichter aufgefunden werden.

Die ersten Reflektorelemente 15 und die zweiten Refelektorelemente 16 bewirken, dass bei Geradeauslauf der Räder (kein Lenkeinschlag) nur die Reflexionen von den ersten Reflektorelementen 15 erfasst werden. Bei einem Lenkeinschlag treten zusätzliche Reflexionen an den zweiten Reflektorelementen 16 an. Bei einem Lenkeinschlag von 45° sind die Reflexionsanteile der ersten Reflektorelemente 15 und der zweiten Reflektorelemente 16 gleichgroß.

Zur Messung des Lenkeinschlags kann die Sende-/Empfangseinrichtung 2 alternativ auch die zusätzliche Empfangsantenne 14 aufweisen, deren Polarisationsebene um 90° zu der Empfangsantenne 13 gedreht ist. Bei Geradeauslauf empfängt die Antenne 14 kein Signal. Mit zunehmendem Lenkeinschlag wird das Signal der Empfangsantenne 14 größer und an der Empfangsantenne 13 kleiner. Die Richtung, ob nach rechts oder links gelenkt wird, erhält man aus dem Phasenunterschied zwischen den beiden ermittelten Reflexionssignalen R der ersten Empfangsantenne 13 und der zweiten Empfangsantenne 14.

Soll die Sensoreinheit Fremdkörper in oder an dem Reifen 7 erkennen können, muss die gesamte Breite des Reifens 7 erfasst werden. Die Sende-/Empfangsantenne 13 muss eine Richtcharakteristik besitzen, die einerseits den gesamten Reifen in der Breite überdeckt und andererseits erfasste Segmente in Umfangsrichtung des Reifens 7 möglichst schmal sind. Somit kann ein Scannen des Reifens 7 in Umfangsrichtung erfolgen. Bei Vorhandensein eines fremden Gegenstandes, beispielsweise eines Nagels, in einem Segment des Reifens 7, ergibt sich ein anderer Reflexionswert R im Vergleich zu den anderen in Umfangsrichtung erfassten Segmenten des Reifens 7.

Die Ansteuerung der Sensoreinheit 1 erfolgt vorzugsweise mittels eines Pseudozufallszahlengenerators, so dass die jeweils den Rädern 5 zugeordneten Sende-/Empfangseinrichtung 2 zeitversetzt angesteuert werden und eine gegenseitige Störung vermieden wird.

**Patentansprüche**

1. Vorrichtung zum Messen und/oder Überwachen von reifenbezogenen Messgrößen eines Fahrzeugs mit einer Sensoreinheit (1) zum Senden, Empfangen und Verarbeiten von Signalen, wobei von einer Antenneneinheit der Sensoreinheit (1) ein Sendesignal (S) in Richtung eines Messobjektes (7) abstrahlbar ist und wobei ein von dem Messobjekt reflektiertes Reflexionssignal (R, R') empfangbar und auswertbar ist, und die Sensoreinheit (1) eine Sende-/Empfangseinrichtung (2) aufweist, mittels derer ein Reflexionsfaktor (S11), der als Quotient aus dem an dem Messobjekt reflektierten Reflexionssignal (R) und dem Sendesignal (S) ausgebildet ist, messbar ist und mittels dessen eine Phasendifferenz zwischen dem Sendesignal (S) und dem Reflexionssignal (R) bestimmbar ist, und die Sende-/Empfangseinrichtung (2) einen vektoriellen Netzwerkanalysator (VNA) und eine Auswerteeinheit (11) aufweist, so dass durch Erfassung der Phasendifferenz zwischen dem Sendesignal (S) und dem Reflexionssignal (R) eine Entfernung zu dem Messobjekt (7) ermittelbar ist, **dadurch gekennzeichnet, dass** in Umfangsrichtung eines Rades orientierte erste Reflektorelemente (15) und quer zu den ersten Reflektorelementen (15) angeordnete zweite Reflektorelemente (16) vorgesehen sind, so dass das Reflexionssignal (R') in Abhängigkeit von einem Lenkeinschlag des Rades (5) veränderlich ist.

2. Vorrichtung nach Anspruch 1, **dadurch gekennzeichnet, dass** die Phasendifferenz für eine Mehrzahl von gleichen und/oder unterschiedlichen Frequenzwerten und/oder in einer vorgegebenen Bandbreite durchführbar ist und dass das Messobjekt ein Reifen (7) ist, so dass aus der ermittelten Entfernung zwischen Sende-/Empfangseinrichtung (2) und dem Reifen (7) eine Federtiefe des Reifens (7) bestimmbar ist.

3. Vorrichtung nach Anspruch 1 oder 2, **dadurch gekennzeichnet, dass** die Auswerteeinheit (11) Auswertemittel aufweist, so dass das im Betrag und Phase vorliegende Reflexionssignal (R) durch inverse Fourier-Transformation in den Zeitbereich transformierbar, in einem Signalprozessor der Sende-/Empfangseinrichtung (2) ein durch die Lage derselben und einem ermittelten Abstand derselben zu dem Messobjekt bestimmten Zeitbereich gefenstert und dass das gefilterte reflektierte Signal (P) durch Fourier-Transformation in den Frequenzbereich zurücktransformierbar ist.

4. Vorrichtung nach einem der Ansprüche 1 bis 3, **dadurch gekennzeichnet, dass** die Sende-/Empfangseinrichtung (2) in einem Radkasten (3) eines Fahrzeugs angeordnet ist und dass das Rad (5) ein kompressibles Strukturelement (6) aufweist, das innerhalb eines durch einen Reifen (7) und einer Felge (8) des Rades (5) begrenzten Innenraumes (9) in Umfangsrichtung des Rades (5) angeordnet ist, und dass die Antenneneinheit (12) der Sende-/Empfangseinrichtung (2) auf das Strukturelement (6) ausgerichtet ist.

5. Vorrichtung nach Anspruch 4, **dadurch gekennzeichnet, dass** das kompressible Strukturelement (6) als ein kreisförmiger Endlosschlauch ausgebildet ist, der in einem Felgenbett (10) der Felge (8) angeordnet und/oder an dieser befestigt ist.

6. Vorrichtung nach Anspruch 4 oder 5, **dadurch gekennzeichnet, dass** das kompressible Strukturelement (6) außenseitig mit einer Anzahl von Reflektorelementen (15, 16) versehen ist.

7. Vorrichtung nach Anspruch 5 oder 6, **dadurch gekennzeichnet, dass** an dem Felgenbett (10) als Messobjekt ein druckabhängiger Mikrowellenhohlraumabsorber (17) mit einem Gehäuse (19) enthaltend eine Längswandung (20), an der eine Antenne (22) befestigt ist, und enthaltend an gegenüberliegenden Seiten der Längswandung (20) angeordneten flexiblen Membranen (21), so dass durch Ermittlung eine Resonanzfrequenz ein Luftdruck des Reifens (7) ableitbar ist.

8. Vorrichtung nach einem der Ansprüche 1 bis 7, **dadurch gekennzeichnet, dass** die Sensoreinheit (1) über ein Pseudozufallszahlengenerator ansteuerbar ist, so dass die jeweils den Rädern (5) zugeordneten Sende-/Empfangseinrichtung (2) zeitlich versetzt zueinander beaufschlagbar sind.

9. Vorrichtung nach einem der Ansprüche 1 bis 8, **dadurch gekennzeichnet, dass** die Sende-/Empfangseinheit (2) eine zusätzliche Antenne (14) aufweist, deren Polarisationsebene um 90° zu der Antenne (13) gedreht ist, so dass aus einem Phasenunterschied durch diese beiden Antennen erfassten Reflexionssignale (R) ein Lenkeinschlag des Rades (5) ermittelbar ist.

10. Vorrichtung nach einem der Ansprüche 1 bis 9, **dadurch gekennzeichnet, dass** die Sende-/Empfangsantenne (13) der Sende-/Empfangseinheit (2) auf eine Breite (b1) der Felge (8) und/oder des Reifens (7) ausgerichtet ist, so dass durch Phasendifferenz des Reflexionssignals (R) zum Sendesignal (S) ein Fremdkörper an dem Reifen (7) ermittelbar ist.

**Claims**

1. A device for measuring and/or monitoring tyre-related variables of a vehicle, comprising a sensor unit (1) for transmitting, receiving and processing signals, wherein a transmission signal (S) can be emitted by an antenna unit of the sensor unit (1) in the direction of an object being measured (7), and wherein a reflection signal (R, R') reflected by the object being measured can be received and analysed, and the sensor unit (1) has a transceiver device (2) by means of which a reflection factor (S11), formed as the quotient from the reflection signal (R) reflected by the object being measured and the transmission signal (S), can be measured and by means of which a phase difference between the transmission signal (S) and the reflection signal (R) can be determined, and the transceiver device (2) has a vector network analyser (VNA) and an analysis unit (11) so that a distance from the object being measured (7) can be established by detecting the phase difference between the transmission signal (S) and the reflection signal (R), **characterised in that** first reflector elements (15) oriented in the circumferential direction of a wheel and second reflector elements (16) arranged transversely to the first reflector elements (15) are provided so that the reflection signal (R') can be modified as a function of a steering lock of the wheel (5).

2. The device according to Claim 1, **characterised in that** the phase difference can be performed for a plurality of similar and/or different frequency values and/or in a predefined bandwidth and the object being measured is a tyre (7) so that a spring depth of the tyre (7) can be determined from the established distance between the transceiver device (2) and the tyre (7).

3. The device according to Claim 1 or 2, **characterised in that** the analysis unit (11) has analysis means so that the reflection signal (R) present in the amount and phase can be transformed by means of an inverse Fourier transform into the time range, in a signal processor of the transceiver unit (2) a time range determined by the position of the same and an established distance of the same from the object being measured is windowed, and the filtered reflected signal (P) can be transformed back by Fourier transform into the frequency range.

4. The device according to any one of Claims 1 to 3, **characterised in that** the transceiver device (2) is arranged in a wheel house (3) of a vehicle and the wheel (5) has a compressible structural element (6) which is arranged inside an inner space (9) delimited by a tyre (7) and a rim (8) of the wheel (5) in the circumferential direction of the wheel (5), and the antenna unit (12) of the transceiver device (2) is aligned with the structural element (6).

5. The device according to Claim 4, **characterised in that** the compressible structural element (6) is formed as a circular endless hose which is arranged in a rim well (10) of the rim (8) and/or is fastened thereto.

6. The device according to Claim 4 or 5, **characterised in that** the compressible structural element (6) is provided on the outer side with a number of reflector elements (15, 16).

7. The device according to Claim 5 or 6, **characterised in that** on the rim well (10) as the object being measured there is a pressure-dependent microwave cavity absorber (17) having a housing (19) containing a longitudinal wall (20), to which an antenna (22) is fastened, and containing flexible membranes (21) arranged on opposite sides of the longitudinal wall (20), so that an air pressure of the tyre (7) can be deduced by establishing a resonance frequency.

8. The device according to any one of Claims 1 to 7, **characterised in that** the sensor unit (1) can be actuated by means of a pseudo random number generator so that the transceiver device (2) assigned to each of the wheels (5) can be acted upon at staggered times to one another.

9. The device according to any one of Claims 1 to 8, **characterised in that** the transceiver unit (2) has an additional antenna (14), the polarisation plane of which is rotated by 90° to the antenna (13) so that a steering lock of the wheel (5) can be established from a phase difference of reflection signals (R) detected by these two antennae.

**10.** The device according to any one of Claims 1 to 9, **characterised in that** the transceiver antenna (13) of the transceiver unit (2) is aligned with a width (b1) of the rim (8) and/or of the tyre (7) so that a foreign body on the tyre (7) can be established by a phase difference of the reflection signal (R) from the transmission signal (S).

## Revendications

**1.** Dispositif de mesure et / ou de surveillance de grandeurs liées aux pneumatiques d'un véhicule, avec une unité de captage (1) pour l'émission, la réception et le traitement de signaux, sachant qu'un signal d'émission (S), en provenance d'une unité d'antenne de l'unité de captage (1), peut être rayonné en direction d'un objet de mesure (7), et sachant qu'un signal de réflexion (R, R'), réfléchi par l'objet de mesure, peut être reçu et évalué, et que l'unité de captage (1) présente une unité d'émission / réception (2), au moyen de laquelle un facteur de réflexion (S11), qui est formé à partir du signal de réflexion (R), réfléchi sur l'objet de mesure, et le signal d'émission (S), peut être mesuré, et qu'une différence de phase entre le signal d'émission (S) et le signal de réflexion (R) peut être déterminée, et que l'unité d'émission / réception (2) présente un catalyseur de réseau vectoriel (VNA) et une unité d'évaluation (11),da manière à ce que, par la saisie de la différence de phase entre le signal d'émission (S) et le signal de réflexion (R), la distance de l'objet de mesure (7) puisse être déterminée, **caractérisé en ce que** des premiers éléments de réflecteur (15), orientés dans la direction circonférentielle d'une roue, et des deuxièmes éléments de réflecteur (16), disposés transversalement par rapport aux premiers éléments de réflecteur (15) sont prévus de manière à ce que le signal de réflexion (R') puisse être modifié en fonction d'un braquage de la roue (5).

**2.** Dispositif selon la revendication 1, **caractérisé en ce que** la différence de phase peut être exécutée pour une pluralité de valeurs de fréquence semblables ou différentes et / ou dans une largeur de bande prédéterminée, et que l'objet de mesure est un pneumatique (7), de manière à ce que, partant de la distance détectée entre l'unité d'émission / réception (2) et le pneumatique (7), une profondeur ressort du pneumatique (7) puisse être déterminée. "

**3.** Dispositif selon revendication 1 ou 2, **caractérisé en ce que** l'unité d'évaluation (11) présente des moyens d'évaluation de manière à ce que le signal de réflexion (R), présent dans le montant et en phase, puisse être transformé dans le domaine du temps, par transformation de Fourier inverse, que, dans un processeur de signaux de l'unité d'émission / réception (2), un domaine de temps, déterminé par la position de celle-ci et une distance détectée entre celle-ci et l'objet de mesure, soit mis en fenêtre, et que le signal réfléchi, filtré (P) puisse être retransformé dans le domaine de fréquence, par transformation de Fourier.

**4.** Dispositif selon l'une des revendications 1 à 3, **caractérisé en ce que** l'unité émission / réception (2) est disposée dans une arche de roue (3) d'un véhicule et que la roue (5) présente un élément de structure compressible (6) qui est disposé dans la direction circonférentielle de la roue (5), dans un espace intérieur (9), limité par un pneumatique (7) et une jante (8) de la roue (5), et que l'unité d'antenne (12) de l'unité émission / réception (2) est dirigée vers l'élément de structure (6).

**5.** Dispositif selon la revendication 4, **caractérisé en ce que** l'élément de structure compressible (6) est réalisé sous la forme d'un tuyau sans fin circulaire, qui est disposé dans un lit de jante (10) de la jante (8) et / ou fixé à celle-ci.

**6.** Dispositif selon revendication 4 ou 5, **caractérisé en ce que** l'élément de structure compressible (6) est pourvu, sur le côté extérieur, d'un nombre d'éléments de réflecteur (15, 16).

**7.** Dispositif selon revendication 5 ou 6, **caractérisé en ce que**, sur le lit de jante (10), est fixé, en tant qu'objet de mesure, un absorbeur de microondes creux (17) asservi à la pression, avec un boîtier (19) comprenant une paroi longitudinale (20), à laquelle est fixée une antenne (22), et comprenant des membranes flexibles (21), disposées sur des côtes opposés de la paroi longitudinale (20), de manière à ce que, par détermination d'une fréquence de résonnance, une pression d'air du pneumatique (7) puisse être dérivée.

**8.** Dispositif selon l'une des revendications 1 à 7, **caractérisé en ce que** l'unité de captage (1) peut être commandée par l'intermédiaire d'un générateur de nombres pseudo aléatoires, de manière à ce que chacune des unités émission / réception (2) respectivement associées aux roues (5) puisse être commandée, décalées dans le temps.

**9.** Dispositif selon l'une des revendications 1 à 8, **caractérisé en ce que** l'unité émission / réception (2) présente une antenne supplémentaire (14), dont le plan de polarisation est tourné de 90 ° par rapport à l'antenne (13), de manière à ce que, par différence de phase, un braquage de la roue (5) puisse être détecté par des signaux de réflexion (R), saisis par ces deux antennes.

**10.** Dispositif selon l'une des revendications 1 à 9, **caractérisé en ce que** l'antenne émission / réception (13) de l'unité émission / réception (2) est orientée sur la largeur (b1) de la jante (8) et / ou du pneumatique (7), de manière à ce que, par différence de phases du signal de réflexion (R) par rapport au signal d'émission (S), un corps étranger puisse être détecté sur le pneumatique (7).

**Fig. 1**

Phasenmessung

Fig. 2

**Fig. 3**

Hilfsebene

Fig. 4

**Fig. 5**

**Fig. 6**

**Fig. 7**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 2461212 A1
- DE 102009013458 A1
- DE 4326976 A1
- WO 03027709 A1

**In der Beschreibung aufgeführte Nicht-Patentliteratur**

- **HEUERMANN, H.** Hochfrequenztechnik. Lineare Komponenten hochintegrierter Schaltungen. Vieweg-Verlag, Mai 2009
- Sichere Verfahren zur Kalibrierung von Netzwerkanalysatoren für koaxiale und planare Leitungssysteme. **HEUERMANN, H.** Dissertationsschrift. Institut für Hochfrequenztechnik, Ruhr-Universität Bochum, 1995